# EUROPÄISCHE PATENTSCHRIFT

(11) **EP 2 621 310 B1**
(45) Veröffentlichungstag und Bekanntmachung des Hinweises auf die Patenterteilung: **25.06.2014**
(21) Anmeldenummer: 12725385.4
(22) Anmeldetag: 31.05.2012
(51) Int. Cl.: A47C 1/024, A47C 20/04

(54) **MÖBELSTÜCK MIT EINEM BETÄTIGUNGSSYSTEM ZUR VERSTELLUNG WENIGSTENS EINES BEWEGLICHEN ELEMENTS**
ITEM OF FURNITURE WITH AN OPERATING SYSTEM FOR ADJUSTING AT LEAST ONE MOVING ELEMENT
PIÈCE DE MOBILIER POURVUE D'UN SYSTÈME D'ACTIONNEMENT POUR DÉPLACER AU MOINS UN ÉLÉMENT MOBILE

(30) Priorität: 16.06.2011 DE 202011050467 U
(43) Veröffentlichungstag der Anmeldung: 07.08.2013
(73) Patentinhaber: CIAR S.P.A., 61100 Pesaro (IT)
(72) Erfinder: MARCANTONI, Egidio, 61122 Pesaro (IT)
(74) Vertreter: Tetzner, Michael
(86) Internationale Anmeldenummer: PCT/EP2012/060299
(87) Internationale Veröffentlichungsnummer: WO 2012/171807

(56) Entgegenhaltungen:
- WO-A2-2009/055432
- WO-A2-2009/114249
- US-A1- 2007 174 965

## Beschreibung

Die Erfindung betrifft ein Möbelstück mit einem Betätigungssystem zur Verstellung wenigstens eines beweglichen Elementes.

Aus der US 2007/0174965 A1 ist ein elektrisch verstellbares Krankenhausbett bekannt, das über ein Steuerpult einstellbar ist. Über diverse Kontrolllampen können Fehlfunktionen, wie niedriger Batteriestand, nicht festgestellte Bremse, etc, angezeigt werden.

Auf dem Möbelmarkt ist eine steigende Nachfrage nach Möbelstücken, wie Stühlen, Sesseln, Sofas, liegen und Betten festzustellen, die mit einem Betätigungssystem zur Verstellung wenigstens eines beweglichen Elementes, wie beispielsweise der Rückenlehne oder einer Fußstütze ausgestattet sind.

Das Betätigungssystem besteht üblicherweise aus einem Linearaktuator, einer Spannungsquelle und einer Handsteuerung, wobei die Spannungsquelle und die Handsteuerung mit der Linearaktuator elektrisch verbunden sind. Diese zusätzliche Technik hat jedoch einen erhöhten Wartungs- und Reparaturaufwand zufolge, wobei viele Einzelhändler mit der Elektronik in Möbelstücken nicht vertraut sind. Es ist immer wieder festzustellen, dass Benutzer bzw. der Reparaturservice bei einem defekten Betätigungssystem nicht in der Lage sind, festzustellen, welches der drei Komponenten (Spannungsquelle, Handsteuerung, Linearaktuator) tatsächlich defekt ist, sodass vielfach das gesamte Betätigungssystem ersetzt wird, wodurch die Reparaturkosten unnötig hoch ausfallen. Der Erfindung liegt daher die Aufgabe zugrunde, Möbelstücke mit einem Betätigungssystem zu schaffen, bei dem auf einfache und kostengünstige Art und Weise zuverlässig festgestellt werden kann, welche der drei Komponenten defekt und auszutauschen ist.

Erfindungsgemäß wird diese Aufgabe durch die Merkmale des Anspruches 1 gelöst.

Das erfindungsgemäße Möbelstück weist wenigstens ein bewegliches Element und ein Betätigungssystem zur Verstellung des beweglichen Elementes auf, wobei das Betätigungssystem wenigstens einen Linearaktuator, eine Spannungsquelle und eine Handsteuerung umfasst, wobei die Spannungsquelle und die Handsteuerung mit dem Linearaktuator elektrisch verbunden sind, wobei die Spannungsquelle über ein Anschlusskabel und die Handsteuerung über ein Anschlusskabel elektrisch mit dem Linearaktuator verbunden sind. Der Linearaktuator weist ferner ein Diagnosesystem mit wenigstens einer Leuchtanzeige zum Anzeigen der Funktion der drei Komponenten auf, wobei die eine oder mehreren Leuchtanzeigen auf einer im Linearaktuator vorgesehenen Schaltungsplatine angeordnet sind..

Mit Hilfe des Diagnosesystems kann schon der Benutzer, spätestens aber der Reparaturservice auf einfache Art und Weise feststellen, welche der drei Komponenten defekt ist, sodass gezielt nur die defekte Komponente ausgetauscht werden muss. Auf diese Weise können etwaige Reparaturkosten deutlich gesenkt werden. Auch der Austausch einer der drei Komponenten kann dann vom Benutzer oder einem Reparaturservice problemlos durchgeführt werden.

Weitere Ausgestaltungen der Erfindung sind Gegenstand der Unteransprüche.

Gemäß einer bevorzugten Ausgestaltung der Erfindung wird die Leuchtanzeige durch eine LED (Licht emittierende Diode) oder eine LCD (Flüssigkristallanzeige) gebildet. Weiterhin ist es denkbar, dass die wenigstens eine Leuchtanzeige wenigstens zwei unterschiedliche Lichtsignale zur Anzeige der Funktion von wenigstens zwei der drei Komponenten aufweist. So kann beispielsweise das eine Lichtsignal durch ein konstantes Licht und das andere Lichtsignal durch ein blickendes Licht gebildet werden.

Weiterhin kann vorgesehen werden, dass eine Leuchtanzeige mit der Spannungsquelle verbunden ist, um Anzuzeigen, ob die Spannungsquelle angeschlossen und aktiv ist. Außerdem kann eine Leuchtanzeige zur Anzeige der Benutzung der Handsteuerung mit dieser in elektrischer Verbindung stehen. In entsprechender Weise kann auch eine Leuchtanzeige zur Anzeige der Betätigung des Linearaktuators an diesen elektrisch angeschlossen sein.

In einer weiteren Ausgestaltung der Erfindung weist das Diagnosesystem wenigstens zwei Leuchtanzeigen mit unterschiedlichen Farben auf. Es wäre aber auch denkbar, ein Leuchtmittel vorzusehen, welches durch entsprechende Ansteuerung in unterschiedlichen Farben leuchten kann. Gemäß einem Ausführungsbeispiel weist das Diagnosesystem wenigstens zwei Leuchtanzeigen auf, wobei die eine mit der Handsteuerung und der Spannungsquelle verbunden ist und die andere Leuchtanzeige zur Anzeige der Betätigung des Linearaktuators dient. Dabei kann auch vorgesehen werden, dass zwei Leuchtanzeigen für den Linearaktuator vorgesehen sind, um unterschiedliche Drehrichtungen des Linearaktuators anzuzeigen.

Das Diagnosesystem kann weiterhin eine mit der Spannungsquelle in Verbindung stehende Leuchtanzeige und eine Blinklichtschaltung aufweisen, wobei ein blickendes Licht an der Leuchtanzeige erzeugt wird, wenn die Spannungsquelle angeschlossen und aktiv ist. Weiterhin kann die Handsteuerung mit derselben Leuchtanzeige wie die Spannungsquelle verbunden sein, wobei die Handsteuerung mehrere Betätigungselemente aufweist, die mit der Leuchtanzeige derart verbunden sind, dass ein Drücken wenigstens eines Betätigungselementes der Handsteuerung ein konstantes Licht der Leuchtanzeige hervorruft.

Die Schaltungsplatine wird zweckmäßigerweise durch eine gedruckte Schaltung gebildet. Gemäß einer weiteren Ausgestaltung der Erfindung ist das Gehäuse zumindest im Bereich der Leuchtanzeigen für das Licht der Leuchtanzeigen durchscheinend ausgebildet ist. Auf diese Weise ist eine besonders kostengünstige Realisierung der Erfindung möglich, darüber hinaus sind die Leuchtanzeigen durch das Gehäuse des Linearaktuators geschützt.

Weitere Vorteile und Ausgestaltungen der Erfindung werden im Folgenden anhand der Beschreibung und der Zeichnung näher erläutert.

In der Zeichnung zeigen
- Fig. 1: eine schematische Darstellung des Betätigungssystems und
- Fig. 2: eine elektrische Schaltung des Betätigungssystem mit Diagnosesystem.

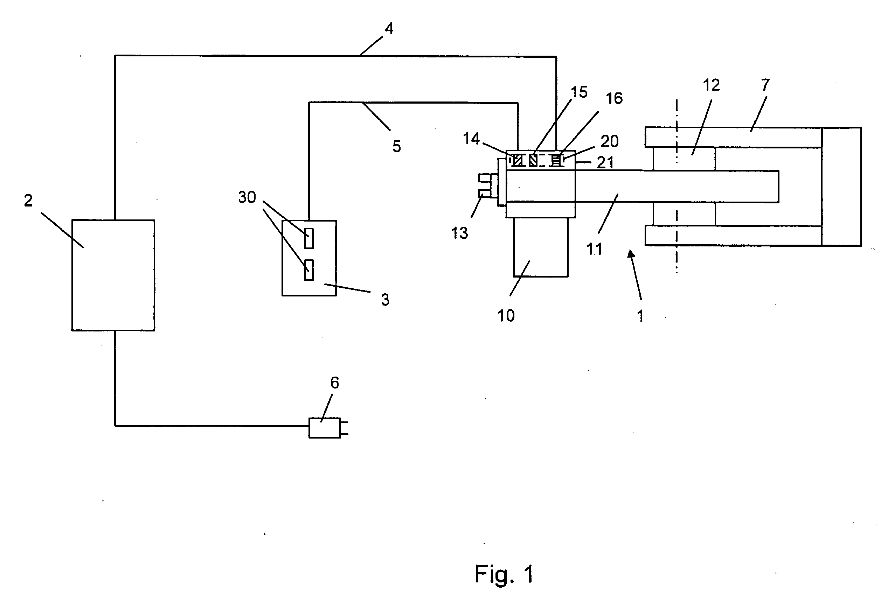

Das in Fig. 1 dargstellte Betätigungssystem besteht im Wesentlichen aus einem Linearaktuator 1, einer Spannungsquelle 2 und einer Handsteuerung 3, wobei die Spannungsquelle 2 über ein Anschlusskabel 4 und die Handsteuerung über ein Anschlusskabel 5 elektrisch mit dem Linearaktuator 1 verbunden sind. Hierzu sind die Anschlusskabel 4 und 5 mit nicht näher dargestellten Steckern versehen, die in entsprechende Buchsen am Linearaktuator 1 einsteckbar sind.

Bei der Spannungsquelle handelt es sich beispielsweise um einen Transformator oder einen Akku. Die Spannungsquelle 2 kann im Bedarfsfall über einen Netzstecker 6 an das Stromnetz angeschlossen werden.

Der Linearaktuator 1 ist in einem nicht näher dargestellten Möbelstück, beispielsweise einem Sessel, einem Sofa, einer Liege, einem Bett oder einer Massageeinrichtung eingebaut und dient zur Verstellung wenigstens eines beweglichen Elementes (7) des Möbelstücks, welches beispielsweise durch die Rückenlehne eines Sessels oder eines Sofas oder eines Teilbereichs eines Bettes gebildet wird.

Der dargestellte Linearaktuator 1 weist im Wesentlichen einen Motor 10, eine Spindel 11 und eine mit der Spindel zusammenwirkende Mutter 12 auf. Der Linearaktuator 1 sieht ferner einen Befestigungsflunsch 13 vor, mit dem er an einem geeigneten Widerlager des Möbelstücks befestigt wird. Das bewegliche Element (7) des Möbelstücks wird mit der Mutter 12 verbunden, sodass eine durch den Motor 10 hervorgerufene Drehbewegung der Spindel 11 eine Verschiebung der Mutter 12 längs der Spindel 11 und damit eine Verstellung des beweglichen Elementes (7) bewirkt.

Das in Fig. 1 dargestellte Betätigungssystem weist ferner ein Diagnosesystem mit drei Leuchtanzeigen 14, 15 und 16 zum Anzeigen der Funktion der drei Komponenten Linearaktuator 1, Spannungsquelle 2 und Handsteuerung 3 auf. Die Leuchtanzeigen werden vorzugsweise durch LEDs gebildet.

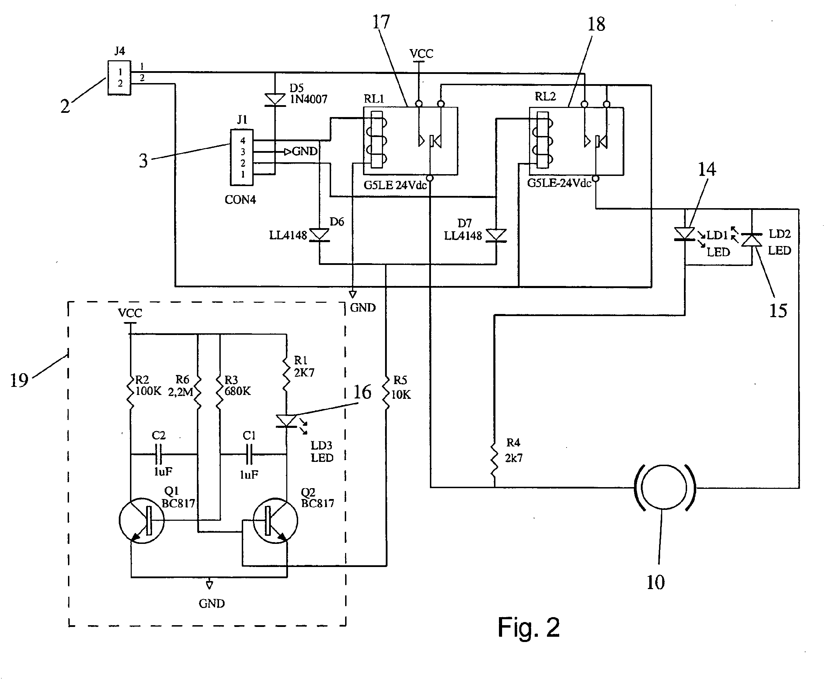

Fig. 2 zeigt den Schaltkreis der in Fig. 1 dargestellten Betätigungseinrichtung mit der angeschlossenen Spannungsquelle 2, der Handsteuerung 3 und dem Motor 10. Zur Ansteuerung des Motors 10 in seinen beiden Drehrichtung sind zwei Relais 17 und 18 vorgesehen, wobei je nach Drehrichtung entweder die Leuchtanzeige 14 oder die Leuchtanzeige 15 leuchten. Zur Unterscheidung der beiden Drehrichtungen können die Leuchtanzeigen unterschiedliche Farben, beispielsweise gelb und rot aufweisen.

Weiterhin ist eine Blinklichtschaltung 19 vorgesehen, die im Wesentlichen zwei Transistoren Q1 und Q2 und die Leuchtanzeige 16 umfasst. Diese Blinklichtschaltung 19 ist mit der Spannungsquelle 2 elektrisch derart verbunden, dass die Leuchtanzeige 16 aufgrund der beiden Transistoren Q1 und Q2 blinkt, wenn die Spannungsquelle 2 angeschlossen und aktiv ist. Durch die blinkende Leuchtanzeige 16 kann Energie gespart werden, was insbesondere bei Verwendung eines Akkus als Spannungsquelle 2 vorteilhaft ist.

Die Handsteuerung 3 weist eine Vielzahl von Betätigungselementen 30 auf, deren Betätigung ebenfalls durch die Leuchtanzeige 16 angezeigt wird. Durch Drücken eines Betätigungselementes 30 an der Handsteuerung 3 wird der Transistor Q2 mit einem konstanten Strom beaufschlagt, sodass die Leuchtanzeige 16 konstant leuchtet. Auf diese Weise kann mit einer Leuchtanzeige sowohl die Funktionsweise der Handsteuerung 3 als auch die Funktionsweise der Spannungsquelle 2 überprüft werden. Zur Unterscheidung von den beiden anderen Leuchtanzeigen 14, 15 wird die Leuchtanzeige 16 beispielsweise durch eine grüne LED gebildet.

Die Leuchtanzeigen 14, 15 und 16 sind zweckmäßigerweise auf einer Schaltungsplatine 20 im Inneren eines Gehäuses 21 des Linearaktuators angeordnet, wobei das Gehäuse zumindest im Bereich der Leuchtanzeigen für das Licht der Leuchtanzeigen durchscheinend ausgebildet ist. Auf diese Weise sind die Leuchtanzeigen vor äußeren Beschädigungen zuverlässig geschützt und können dennoch wahrgenommen werden.

Im Folgenden wird die Betriebsweise und die Fehleranzeige des Diagnosesystems näher beschrieben:

### Normalbetrieb:

| A) Standby: | |
|---|---|
| Grüne Leuchtanzeige 16: | blinkt |
| Rote und gelbe Leuchtanzeige 14, 15: | sind aus |

| B) Betätigungselement 30 für "Motor auf" ist gedrückt: | |
|---|---|
| Grüne Leuchtanzeige 16: | leuchtet konstant |
| Gelbe Leuchtanzeige 14: | leuchtet |

| C) Betätigungselement 30 für "Motor ab" ist gedrückt: | |
|---|---|
| Grüne Leuchtanzeige 16: | leuchtet konstant |
| Rote Leuchtanzeige 15: | leuchtet |

### Fehler an der Spannungsquelle (Betätigungssystem reagiert überhaupt nicht):

| | |
|---|---|
| Symptom: | Standbybetrieb oder Betätigung eines Betätigungselementes 30: alle Leuchtanzeigen sind aus |
| Diagnose: | Spannungsquelle ist defekt oder Netzstecker 6 ist nicht eingesteckt |
| Lösung: | Überprüfung der Stromverbindung. Sofern die Verbindung in Ordnung sind, muss die Spannungsquelle 2 ersetzt werden. |

Für die folgenden Fälle wird angenommen, dass die Spannungsquelle funktioniert, d.h. die Leuchtanzeige 16 blinkt.

### Fehler an der Handsteuerung 3:

| | |
|---|---|
| Symptom: | Obwohl Betätigungselemente 30 an der Handsteuerung 3 gedrückt werden, leuchtet die Leuchtanzeige 16 nicht konstant auf (natürlich leuchten auch die Leuchtanzeigen 14 und 15 in diesem Fall nicht) |
| Diagnose: | Der Befehl der Handsteuerung 3 erreicht nicht die Relais 17, 18. Dies bedeutet, dass entweder das Anschlusskabel 5 der Handsteuerung 3 oder die Anschlussverbindung am Linearaktuator 1 beschädigt ist. |
| Lösung: | Austauschen der Handsteuerung. Sollte das Problem weiterhin bestehen, kann das Problem nur an der Buchse für die Handsteuerung 3 am Linearaktuator bestehen. In diesem Fall ist der Linearaktuator 1 auszutauschen. |
| Symptom: | Ein Betätigungselement 30 ist okay, aber die Betätigung eines anderen Betätigungselementes ruft kein konstantes Licht der Leuchtanzeige 16 hervor. |
| Diagnose: | Beschädigtes Betätigungselement 30 an der Handsteuerung 3, beschädigtes Anschlusskabel 5 oder beschädigte Anschlussverbindung am Linearaktuator 1 |
| Lösung: | Austauschen des Handgerätes 3. Sollte das Problem weiterhin bestehen, kann das Problem nur an der Buchse für die Handsteuerung 3 am Linearaktuator 1 bestehen. In diesem Fall ist der Linearaktuator 1 auszutauschen. |

Für die folgenden Fälle wird angenommen, dass die Spannungsquelle funktioniert, d.h. die Leuchtanzeige 16 blinkt im Standby-Betrieb. Weiterhin wird angenommen, dass beim Drücken eines Betätigungselements 30 der Handsteuerung 3 die Leuchtanzeige 16 konstant leuchtet und die Handsteuerung 3 funktioniert.

### Fehler an Linearaktuator 1:

| | |
|---|---|
| Symptom: | Durch Drücken eines Betätigungselementes 30 leuchtet weder die Leuchtanzeige 14 noch die Leuchtanzeige 15 auf und der Motor 10 bewegt sich nicht. |
| Diagnose: | Relais 17 oder 18 ist defekt. |
| Lösung: | Austausch des Linearaktuators 1 |
| Symptom: | Durch Betätigen eines Betätigungselementes 30 der Handsteuerung 3 leuchtet einer der beiden Anzeigen 14 oder 15 auf, aber der Motor bewegt sich nicht. |
| Diagnose: | Der Motor oder die Motoransteuerung sind defekt. |
| Lösung: | Austausch des Linearaktuators 1. |

Mit dem oben beschriebenen Diagnosesystem ist für jedermann schnell und einfach nachprüfbar, welche der drei Komponenten defekt und auszutauschen ist. Die Realisierung mit geeigneten Leuchtanzeigen, insbesondere in Form von farbigen LEDs, ist sehr kostengünstig.

## Patentansprüche

1. Möbelstück mit wenigstens einem beweglichen Element (7) und einem Betätigungssystem zur Verstellung des beweglichen Elements, wobei das Betätigungssystem wenigstens einen Linearaktuator (1), eine Spannungsquelle (2) und eine Handsteuerung (3) umfasst und die Spannungsquelle (2) und die Handsteuerung mit dem Linearaktuator (1) elektrisch verbunden sind, wobei die Spannungsquelle (2) über ein Anschlusskabel (4) und die Handsteuerung über ein Anschlusskabel (5) elektrisch mit dem Linearaktuator (1) verbunden sind,
**dadurch gekennzeichnet, dass** der Linearaktuator (1) ein Diagnosesystem mit wenigstens einer Leuchtanzeige (14, 15, 16) zum Anzeigen der Funktion der drei Komponenten aufweist, wobei die eine oder mehreren Leuchtanzeigen (14, 15, 16) auf einer im Linearaktuator vorgesehenen Schaltungsplatine (20) angeordnet sind.

2. Möbelstück nach Anspruch 1, **dadurch gekennzeichnet, dass** die Leuchtanzeige (14, 15, 16) durch eine LED oder eine LCD gebildet wird.

3. Möbelstück nach einem oder mehreren der vorhergehenden Ansprüche, **dadurch gekennzeichnet, dass** die wenigstens eine Leuchtanzeige (16) wenigstens zwei unterschiedliche Lichtsignale zur Anzeige der Funktion von wenigstens zwei der drei Komponenten aufweist.

4. Möbelstück nach Anspruch 1, **dadurch gekennzeichnet, dass** wenigstens eines der wenigstens zwei Lichtsignale ein konstantes Licht und das andere Lichtsignal ein blinkendes Licht ist.

5. Möbelstück nach einem oder mehreren der vorhergehenden Ansprüche, **dadurch gekennzeichnet, dass** eine Leuchtanzeige (16) mit der Spannungsquelle (2) verbunden ist, um Anzuzeigen, ob die Spannungsquelle (2) angeschlossen und aktiv ist.

6. Möbelstück nach einem oder mehreren der vorhergehenden Ansprüche, **dadurch gekennzeichnet, dass** eine Leuchtanzeige (16) zur Anzeige der Benutzung der Handsteuerung (3) mit dieser in elektrischer Verbindung steht.

7. Möbelstück nach einem oder mehreren der vorhergehenden Ansprüche, **dadurch gekennzeichnet, dass** wenigstens eine Leuchtanzeige (14, 15) zur Anzeige der Betätigung des Linearaktuators (1) mit diesem in elektrischer Verbindung steht.

8. Möbelstück nach einem oder mehreren der vorhergehenden Ansprüche, **dadurch gekennzeichnet, dass** das Diagnosesystem wenigstens zwei Leuchtanzeigen (14, 15, 16) mit unterschiedlichen Farben aufweist.

9. Möbelstück nach einem oder mehreren der vorhergehenden Ansprüche, **dadurch gekennzeichnet, dass** das Diagnosesystem wenigstens zwei Leuchtanzeigen (14, 15, 16) aufweist, wobei die eine (16) mit der Handsteuerung (3) und der Spannungsquelle verbunden ist und die andere Leuchtanzeige (14, 15) zur Anzeige der Betätigung des Linearaktuators (1) mit diesem in Verbindung steht.

10. Möbelstück nach Anspruch 1, **dadurch gekennzeichnet, dass** zwei Leuchtanzeigen (14, 15) zur Anzeige der Betätigung des Linearaktuators (1) in zwei unterschiedlichen Richtungen mit diesem in Verbindung stehen.

11. Möbelstück nach einem oder mehreren der vorhergehenden Ansprüche, **dadurch gekennzeichnet, dass** das Diagnosesystem eine mit der Spannungsquelle (2) in Verbindung stehende Leuchtanzeige (16) und eine Blinklichtschaltung (19) zur Erzeugung eines blinkenden Lichts an der Leuchtanzeige (16) aufweist, wenn die Spannungsquelle (2) angeschlossen und aktiv ist.

12. Möbelstück nach Anspruch 11, **dadurch gekennzeichnet, dass** die Handsteuerung (3) mit derselben Leuchtanzeige (16) wie die Spannungsquelle (2) verbunden ist und die Handsteuerung (3) mehrere Betätigungselemente (30) aufweist, die mit der Leuchtanzeige (16) derart verbunden sind, dass ein Drücken wenigstens eines Betätigungselementes der Handsteuerung ein konstantes Licht der Leuchtanzeige (16) hervorruft.

13. Möbelstück nach Anspruch 1, **dadurch gekennzeichnet, dass** der Linearaktuator (1) ein Gehäuse (21) aufweist und die Schaltungsplatine (20) mit den Leuchtanzeigen (14, 15, 16) im Inneren des Gehäuses (21) angeordnet ist, wobei das Gehäuse zumindest im Bereich der Leuchtanzeigen für das Licht der Leuchtanzeigen (14, 15, 16) durchscheinend ausgebildet ist.

## Claims

1. Item of furniture having at least one movable element (7) and an actuating system for adjusting the movable element, wherein the actuating system comprises at least one linear actuator (1), a power supply unit (2) and a manual control device (3), and the power supply unit (2) and the manual control device are electrically connected to the linear actuator (1), wherein the power supply unit (2) being electrically connected to the linear actuator (1) by way of a connecting cable (4) and the manual control device being electrically connected to the linear actuator (1) by way of a connecting cable (5),
**characterised in that** the linear actuator (1) has a diagnostic system having at least one illuminated indicator (14, 15, 16) for indicating the functioning of the three components, wherein the one or more illuminated indicators (14, 15, 16) are disposed on a circuit board (20) inside the linear actuator.

2. Item of furniture according to claim 1, **characterised in that** the illuminated indicator (14, 15, 16) is formed by an LED or an LCD.

3. Item of furniture according to one or more of the preceding claims, **characterised in that** the at least one illuminated indicator (16) has at least two different light signals for indicating the functioning of at least two of the three components.

4. Item of furniture according to claim 1, **characterised in that** at least one of the at least two light signals is a steady light and the other light signal is a blinking light.

5. Item of furniture according to one or more of the preceding claims, **characterised in that** an illuminated indicator (16) is connected to the power supply unit (2) in order to indicate whether the power supply unit (2) is connected and active.

6. Item of furniture according to one or more of the preceding claims, **characterised in that** an illuminated indicator (16) for indicating the use of the manual control device (3) is in electrical connection with the manual control device (3).

7. Item of furniture according to one or more of the preceding claims, **characterised in that** at least one illuminated indicator (14, 15) for indicating the actuation of the linear actuator (1) is in electrical connection with the linear actuator (1).

8. Item of furniture according to one or more of the preceding claims, **characterised in that** the diagnostic system has at least two illuminated indicators (14, 15, 16) of different colours.

9. Item of furniture according to one or more of the preceding claims, **characterised in that** the diagnostic system has at least two illuminated indicators (14, 15, 16), wherein one (16) is connected to the manual control device (3) and the power supply unit and the other illuminated indicator (14, 15) is connected to the linear actuator (1) in order to indicate the actuation thereof.

10. Item of furniture according to claim 1, **characterised in that** two illuminated indicators (14, 15) are connected to the linear actuator (1) in order to indicate the actuation thereof in two different directions.

11. Item of furniture according to one or more of the preceding claims, **characterised in that** the diagnostic system has an illuminated indicator (16) connected to the power supply unit (2), and a blinking light circuit (19) for producing a blinking light on the illuminated indicator (16) when the power supply unit (2) is connected and active.

12. Item of furniture according to claim 11, **characterised in that** the manual control device (3) is connected to the same illuminated indicator (16) as the power supply unit (2), and the manual control device (3) has a plurality of actuating elements (30) which are so connected to the illuminated indicator (16) that a steady light is produced on the illuminated indicator (16) when at least one actuating element of the manual control device is pressed.

13. Item of furniture according to claim 1, **characterised in that** the linear actuator (1) has a housing (21), and the circuit board (20) is disposed inside the housing (21) with the illuminated indicators (14, 15, 16), the housing being transparent to the light of the illuminated indicators (14, 15, 16) at least in the region of the illuminated indicators.

## Revendications

1. Pièce de mobilier pourvue d'au moins un élément mobile (7) et d'un système d'actionnement pour le déplacement dudit élément mobile, sachant que le système d'actionnement comprend au moins un actionneur linéaire (1), une source de tension (2) et une commande manuelle (3) et que la source de tension (2) et la commande manuelle sont reliées électriquement à l'actionneur linéaire (1), la source de tension (2) et la commande manuelle étant reliées électriquement à l'actionneur linéaire (1), l'une par l'intermédiaire d'un câble de raccordement (4) et l'autre par l'intermédiaire d'un câble de raccordement (5),
**caractérisée en ce que** l'actionneur linéaire (1) comprend un système de diagnostic, qui est doté d'au moins un affichage lumineux (14, 15, 16) destiné à l'affichage de la fonction des trois composants, sachant qu'un ou plusieurs affichages lumineux (14, 15, 16) sont disposés sur une plaquette de circuits (20) qui est prévue dans l'actionneur linéaire.

2. Pièce de mobilier selon la revendication 1,
**caractérisée en ce que** l'affichage lumineux (14, 15, 16) est formé par une LED ou par une LCD.

3. Pièce de mobilier selon l'une ou plusieurs des revendications précédentes,
**caractérisée en ce que** l'affichage lumineux (16) au moins prévu comprend au moins deux signaux lumineux différents pour afficher le fonctionnement d'au moins deux des trois composants.

4. Pièce de mobilier selon la revendication 1,
**caractérisée en ce qu'**au moins l'un des deux signaux lumineux au moins prévus consiste en une lumière constante et que l'autre signal lumineux consiste en une lumière clignotante.

5. Pièce de mobilier selon l'une ou plusieurs des revendications précédentes,
**caractérisée en ce qu'**un affichage lumineux (16) est relié à la source de tension (2) pour indiquer si ladite source de tension (2) est raccordée et activée.

6. Pièce de mobilier selon l'une ou plusieurs des revendications précédentes.
**caractérisée en ce qu'**un affichage lumineux (16) est raccordé électriquement à la commande manuelle (3) pour indiquer l'utilisation de celle-ci.

7. Pièce de mobilier selon l'une ou plusieurs des revendications précédentes,
**caractérisée en ce qu'**au moins un affichage lumineux (14, 15) est raccordé électriquement à l'actionneur linéaire (1) pour indiquer l'actionnement de celui-ci.

8. Pièce de mobilier selon l'une ou plusieurs des revendications précédentes,
**caractérisée en ce que** le système de diagnostic est doté au moins de deux affichages lumineux (14, 15, 16) de différentes couleurs.

9. Pièce de mobilier selon l'une ou plusieurs des revendications précédentes,
**caractérisée en ce que** le système de diagnostic est doté au moins de deux affichages lumineux (14, 15, 16), sachant que l'un (16) est en connexion avec la commande manuelle (3) et la source de tension et que l'autre affichage lumineux (14, 15) est en connexion avec l'actionneur linéaire (1) pour indiquer l'actionnement de celui-ci.

10. Pièce de mobilier selon la revendication 1,
**caractérisée en ce que** deux affichages lumineux (14, 15) sont en connexion avec l'actionneur linéaire (1) pour indiquer l'actionnement de celui-ci dans deux directions différentes.

11. Pièce de mobilier selon l'une ou plusieurs des revendications précédentes,
**caractérisée en ce que** le système de diagnostic présente un affichage lumineux (16), qui est en connexion avec la source de tension (2), et un circuit clignotant (19), qui est destiné à générer une lumière clignotante sur l'affichage lumineux (16) quand la source de tension (2) est connectée et activée.

12. Pièce de mobilier selon la revendication 11,
**caractérisée en ce que** la commande manuelle (3) est raccordée au même affichage lumineux (16) que la source de tension (2) et que la commande manuelle (3) est dotée de plusieurs éléments d'actionnement (30), qui sont reliés à l'affichage lumineux (16) de telle manière qu'une pression, exercée sur au moins un élément d'actionnement de la commande manuelle, provoque un éclairage constant de l'affichage lumineux (16).

13. Pièce de mobilier selon la revendication 1,
**caractérisée en ce que** l'actionneur linéaire (1) est doté d'un boîtier (21) et que la plaquette de circuits (20), avec les affichages lumineux (14, 15, 16), est logée à l'intérieur du boîtier (21), sachant que le boîtier est transparent à la lumière des affichages lumineux (14, 15, 16), au moins dans la région des affichages lumineux.
